# EUROPÄISCHE PATENTANMELDUNG

(11) **EP 2 133 889 A1**
(43) Veröffentlichungstag der Anmeldung: **16.12.2009**
(21) Anmeldenummer: 08010690.9
(22) Anmeldetag: 12.06.2008
(51) Int. Cl.: H01F 27/40, H01F 37/00, G01R 31/14, G01R 31/06

(54) **Drossel und Prüfanordnung mit Drossel**

(71) Anmelder: ABB Technology AG, 8050 Zürich (CH)
(72) Erfinder: Szczechowski, Janusz, Dipl.-Ing, 04229 Leipzig (DE)
(74) Vertreter: Partner, Lothar

(57) **Zusammenfassung**

Die Erfindung betrifft eine Hochspannungsdrossel (10, 68, 70, 108, 110, 160) mit wenigstens einem elektrischen Leiter, welcher in einer Vielzahl von Windungen um eine Wickelachse angeordnet (14) ist, wobei die Windungen radial einen Innenraum (12) längs der Wickelachse (14) umschließen. In diesem Innenraum (12) ist wenigstens eine elektrische Innenkomponente (22, 24, 76, 164, 166) angeordnet. Die Erfindung betrifft weiterhin eine Prüfanordnung (50) zur Wechselspannungsprüfung von elektrischen Hochspannungskomponenten (172) mit wenigstens einem Wechselrichter (54, 152), mit wenigstens einem Prüftransformator (58, 158) und mit wenigstens einer erfindungsgemäßen Hochspannungsdrossel (10, 68, 70, 108, 110, 160) als Prüfkomponenten, wobei wenigstens die genannten Prüfkomponenten in einem gemeinsamen quaderförmigen Behälter (52, 124) angeordnet sind.

## Beschreibung

Die Erfindung betrifft eine Hochspannungsdrossel mit wenigstens einem elektrischen Leiter, welcher in einer Vielzahl von Windungen um eine Wickelachse angeordnet ist, wobei die Windungen radial einen Innenraum längs der Wickelachse umschließen. Die Erfindung betrifft weiterhin eine Prüfanordnung zur Wechselspannungsprüfung von elektrischen Hochspannungskomponenten mit wenigstens einem Wechselrichter, mit wenigstens einem Prüftransformator und mit wenigstens einer Hochspannungsdrossel als Prüfkomponenten, wobei wenigstens die genannten Prüfkomponenten in einem gemeinsamen quaderförmigen Behälter angeordnet sind.

Transformatoren werden infolge des schwierigen Transports zunehmen vor Ort repariert. Um die Qualität der Reparatur abschließend beurteilen zu können, muss wie im Reparaturwerk eine abschließende Hochspannungsprüfung erfolgen.

Es ist allgemein bekannt, dass Hochspannungskomponenten, wie beispielsweise Leistungstransformatoren, einem Alterungsprozess unterworfen sind, welcher insbesondere die elektrische Isolation betrifft. Von daher sind zur Sicherstellung eines fehlerfreien Betriebes eines elektrischen Energieverteilungsnetzes mit derartigen Hochspannungskomponenten in bestimmten Zeitintervallen Prüfungen, insbesondere der Leistungstransformatoren, sinnvoll. Eine derartige Prüfung ist auch nach einer Reparatur oder Wartung eines Transformators sinnvoll bzw. erforderlich. Derartige Prüfungen geben Aufschluss über den Zustand beispielsweise der Isolation und ermöglichen auch die Detektion anderer Fehler der betreffenden Hochspannungskomponente.

Hochspannungskomponenten wie Leistungstransformatoren weisen ein sehr hohes Gewicht auf, je nach elektrischer Nennleistung auch über 100t. Ein Transport eines derartigen innerhalb eines elektrischen Energieverteilungsnetzes eingebauten Leistungstransformators in ein fest installiertes Prüffeld, in welchem dieser mittels einer Wechselspannungsprüfung geprüft werden könnte, ist aufgrund des hohen Transportaufwandes für den jeweiligen Leistungstransformator praktisch ausgeschlossen. Zudem ist in den seltensten Fällen genügend Redundanz in einem Energieverteilungsnetz vorhanden, dass ein Leistungstransformator ohne Beeinträchtigung des Netzbetriebes ausgebaut werden könnte.

Aus diesem Grund erfolgen derartige Wechselspannungsprüfungen von Leistungstransformatoren zumeist vor Ort. Die Prüfanordnung mit Wechselspannungsgenerator sowie weiteren für die Prüfung benötigten Komponenten wie Hochspannungsdrossel, Spannungsteiler, Mess- und Auswertevorrichtungen wird in mehreren Baugruppen zu dem Ort, an dem sich der zu prüfende Leistungstransformator befindet, transportiert und dort zu einer Prüfanordnung montiert. Insbesondere die Hochspannungsdrossel, welche für eine Resonanzprüfung zur Bildung eines Resonanzschwingkreises mit dem Prüfling benötigt wird, kann mit einer Höhe von beispielsweise ca. 2,5m und einem Innendurchmesser von beispielsweise 1m eine Prüfkomponente von beachtlicher Größe darstellen. Auch der Spannungsteiler, welcher zur Messung der hohen Spannungen von beispielsweise bis zu 500kV im Resonanzschwingkreis benötigt wird, ist eine Komponente mit ähnlicher Höhe.

Bei der Durchführung einer Wechselspannungsprüfung ist darauf zu achten, dass die Komponenten der Prüfanordnung aufgrund der hohen auftretenden Spannungen einen genügend großen Abstand zueinander und zu angrenzendem Erdpotential aufweisen.

Nachteilig ist, dass die Montage der verschiedenen Baugruppen vor Ort mit einem erheblichen Zeitaufwand verbunden ist. Insbesondere die Positionierung und Montage einer Hochspannungsdrossel oder eines Spannungsteilers sind sehr zeitaufwändig.

Ausgehend von diesem Stand der Technik ist es Aufgabe der Erfindung, eine Prüfanordnung oder geeignete Prüfkomponenten hierfür anzugeben, welche einen geringeren Platzbedarf aufweisen und in einer verringerten Anzahl von Baugruppen transportierbar sind.

Diese Aufgabe wird erfindungsgemäß gelöst durch eine Hochspannungsdrossel mit den im Anspruch 1 angegebenen Merkmalen.

Demgemäß kennzeichnet sich die Hochspannungsdrossel der eingangs genannten Art dadurch, dass in deren Innenraum wenigstens eine elektrische Innenkomponente angeordnet ist. Bei der Anordnung sind insbesondere isolationstechnische Anforderungen zwischen der Wicklung der Hochspannungsdrossel und der Innenkomponente zu erfüllen. Demgemäß ist es zweckmäßig, einen Wickelkörper, um den die Windungen der Hochspannungsdrossel üblicherweise angeordnet sind, in einem Isolationsmaterial von hinreichender Dicke, je nach Spannungsbeanspruchung beispielsweise einige Zentimeter, auszuführen.

Die Anordnung von elektrischen Komponenten im Innenraum einer Hochspannungsdrossel nutzt in vorteilhafter Weise den dort zur Verfügung stehenden Platz.

In einer bevorzugten Ausgestaltung der erfindungsgemäßen Hochspannungsdrossel ist die wenigstens eine elektrische Innenkomponente ein Kondensator, ein Widerstand, eine Induktivität oder eine Funkenstrecke. Dies sind die typischen elektrischen Komponenten, welche in einer Prüfanordnung für Wechselspannungsprüfungen verschaltet sind. Zudem sind diese aufgrund ihrer Größe einfach in den Innenraum einer Hochspannungsdrossel integrierbar und reduzieren den Platzbedarf für eine Prüfanordnung, in welcher die Innenraumkomponenten verschaltet sind.

Sinnvollerweise sind die Hochspannungsdrossel und die wenigstens eine elektrische Innenkomponente für eine Nennspannung von wenigstens 50kV ausgelegt, wobei sich die Nennspannung nach der in einer Prüfanordnung während eines Wechselspannungstests maximal auftretenden Spannung richtet, welche je nach Prüfanordnung für einige Komponenten auch 500kV beträgt. Bei Reihenschaltung mehrerer elektrischer Komponenten verringert sich deren Spannungsbelastung entsprechend deren Anzahl, beispielsweise bei einem Spannungsteiler.

In einer Variante der erfindungsgemäßen Hochspannungsdrossel ist wenigstens eine elektrische Innenkomponente elektrisch mit wenigstens einer weiteren elektrischen Komponente verschaltet.

Eine derartige Verschaltung ist beispielsweise die elektrische Reihenschaltung von wenigstens zwei Komponenten, welche vorzugsweise längs der Wickelachse der Hochspannungsdrossel als Innenkomponenten angeordnet sind. Die Anordnung mehrerer Komponenten in elektrischer Reihenschaltung ist in dem vorzugsweise länglichen Innenraum der Hochspannungsdrossel besonders einfach realisierbar.

Die genannte Ausführungsform mit Kondensatoren bietet zudem den Vorteil, dass die Funktionalität eines Spannungsteilers gebildet ist, welcher in verschiedenen Prüfanordnungen für Wechselspannungstest benötigt wird und platzsparend innerhalb der Hochspannungsdrossel untergebracht ist. Eine derartige Ausführungsform eines Spannungsteilers mit ohmschen Widerständen ist ebenso realisierbar.

Die erfindungsgemäße Aufgabe wird auch gelöst durch eine Prüfanordnung der eingangs genannten Art. Diese ist **dadurch gekennzeichnet, dass** die wenigstens eine Hochspannungsdrossel als erfindungsgemäße Hochspannungsdrossel mit wenigstens einer in deren Innenraum angeordneten elektrischen Innenkomponente ausgeführt ist.

Die Vorteile einer platzsparenden Anordnung von wenigstens einer Innenkomponente sind somit auch in einer Prüfanordnung nutzbar, deren Platzbedarf dadurch ebenfalls reduziert wird.

In einer bevorzugten Ausgestaltung der erfindungsgemäßen Prüfanordnung ist die wenigstens eine elektrische Innenkomponente der Hochspannungsdrossel als Teil eines elektrischen Spannungsteilers in der Prüfanordnung verschaltet. Ein Spannungsteiler ist wie eingangs erwähnt eine Komponente von beachtlicher Größe, welche somit platzsparend zumindest teilweise in die Hochspannungsdrossel integriert ist.

In einer weiteren Ausführungsform der erfindungsgemäßen Prüfanordnung umfasst diese einen elektrischen Resonanzschwingkreis mit wenigstens der Hochspannungsdrossel und einer zu prüfenden Hochspannungskomponente sowie den damit verschalteten Spannungsteiler.

Ein Resonanzschwingkreis ist eine einfache Möglichkeit, hohe Prüfspannungen zu erzeugen. Aufgrund der Höhe der erzeugten Prüfspannungen von beispielsweise 500kV beträgt die isolationstechnisch erforderliche Länge eines entsprechenden Spannungsteilers etwa 2,5m, wie dem Fachmann jedoch bekannt ist. Diese Länge entspricht in etwa auch der Länge einer bevorzugten Ausführungsform einer erfindungsgemäßen Hochspannungsdrossel, welche beispielsweise einen lichten Innendurchmesser von ca. 1 m aufweist.

Somit sind bei einem Resonanzschwingkreis Hochspannungsdrossel und Spannungsteiler derart ausgeführt, dass sie besonders gut in Form einer erfindungsgemäßen Hochspannungsdrossel ineinander integriert sind.

Erfindungsgemäß ist der Resonanzschwingkreis mittels des Wechselrichters und des mit diesem elektrisch verbundenen Prüftransformators anregbar. Die elektrische Leistung eines derartigen Wechselrichters beträgt beispielsweise mehrere 100kVA . Der Wechselrichter erzeugt eine Wechselspannung variabler Frequenz, wobei diese auf die Resonanzfrequenz des Schwingkreises geregelt ist. Diese ist zunächst von der Kapazität bzw. Induktivität des Prüflings abhängig, aber auch von der Induktivität der Hochspannungsdrossel und der Kapazität des Spannungsteilers. Die Prüfkomponenten sind derart zu bemessen, dass die Resonanzfrequenz bei typischen Prüflingen ca. 100Hz nicht übersteigt.

Durch die Anregung des Schwingkreises in seiner Resonanzfrequenz sind besonders einfach hohe Spannungen erzeugbar.

In einer weiteren Ausgestaltung der erfindungsgemäßen Prüfanordnung ist die Hochspannungsdrossel mittels einer Bewegungsvorrichtung durch wenigstens eine Öffnung an einer Begrenzungsfläche des Behälters zumindest teilweise aus diesem bewegbar.

Die Isolationsabstände zwischen der Hochspannungsdrossel und weiteren angrenzenden Komponenten beziehungsweise angrenzendem Erdpotential sind hierdurch vorteilhaft steigerbar. Somit ist bei einer ersten Anordnungsvariante der Hochspannungsdrossel innerhalb des Behälters eine besonders platzsparende Anordnung gegeben, welche den Transport der Prüfanordnung vereinfacht. Bei einer weiteren Anordnungsvariante der Hochspannungsdrossel außerhalb des Behälters sind die Isolationsabstände erhöht, was den Betrieb der Anordnung ermöglicht oder zumindest isolationstechnisch sicherer gestaltet. Der Wechsel zwischen den Anordnungsvarianten erfolgt durch die Bewegungsvorrichtung in besonders einfacher Form.

In einer Variante der Prüfanordnung ist die wenigstens eine Öffnung an der oberen Begrenzungsfläche des Behälters befindlich und die Bewegungsvorrichtung wirkt vorwiegend in vertikaler Richtung. Somit ist ein vertikales Herausbewegen der Hochspannungsdrossel durch die Dachseite des Behälters ermöglicht. Ein Beispiel für eine geeignete Bewegungsvorrichtung ist eine hydraulische Hebevorrichtung.

In einer weiteren Variante der Prüfanordnung ist die wenigstens eine Öffnung an einer senkrechten Begrenzungsfläche des Behälters befindlich und die Bewegungsvorrichtung wirkt vorwiegend in horizontaler Richtung. Somit ist ein horizontales Herausbewegen der Hochspannungsdrossel zu einer Seite oder einer Stirnfläche des Behälters ermöglicht. Ein Beispiel für eine geeignete Bewegungsvorrichtung ist eine Teleskopschiene.

In einer bevorzugten Ausgestaltung der erfindungsgemäßen Anordnung ist die horizontal wirkende Bewegungsvorrichtung mit der zumindest teilweise aus dem Behälter bewegten Hochspannungsdrossel nach unten mittels einer Stützvorrichtung abstützbar. Eine derartige Abstützvorrichtung ist - ähnlich wie bei einem gegen Kippen zu sichernden mobilen Kran - beispielsweise eine in einem senkrechten Gewindekanal angeordnete Spindel, welche durch eine Drehbewegung derart längs des Gewindekanals bewegbar ist, dass sie eine Stütze zwischen der Bewegungsvorrichtung und dem Untergrund bildet. Es ist aber auch eine Vielzahl von weiteren dem Fachmann bekannten Ausführungsformen einer Abstützvorrichtung möglich.

Die an der Aussenkante des Behälters wirkende maximale Drehmomentbelastung der Bewegungsvorrichtung ist dadurch reduziert und deren Konstruktion wird vereinfacht. Zudem steigt die Standsicherheit des Behälters.

Vorteilhafterweise ist die wenigstens eine Öffnung des Behälters verschließbar. Bei einem Transport des Behälters mit geschlossener Öffnung sind die in ihm befindlichen Komponenten der Prüfanordnung somit besser geschützt.

In einer Ausgestaltung der Prüfanordnung ist der Behälter mit einer Transportvorrichtung verbunden ist, welche sie tragende Räder aufweist, beispielsweise ein LKW mit Auflieger. Der Transport der Prüfanordnung wird dadurch vereinfacht.

Besonders bevorzugt ist in diesem Zusammenhang die Ausgestaltung des Behälters als Container mit Standardabmessung, beispielsweise als Container mit 40 Fuß Länge. Dieser ist in einer weiteren Variante gemäß CSC (Container Safety Convention) zugelassen und somit in jeder beliebigen Position innerhalb eines Containerstapels auf einem Containerschiff platzierbar. Hierdurch wird die Transportierbarkeit der Prüfanordnung noch weiter erhöht.

In einer bevorzugten Ausführungsform der Prüfanordnung sind die Prüfkomponenten zumindest teilweise mittels isolierter Hochspannungskabel elektrisch miteinander verbunden. Der aus Isolationsgründen bedingte Mindestabstand zwischen den Prüfkomponenten ist dadurch weiter reduzierbar.

In einer weiteren Ausgestaltung der Prüfanordnung ist wenigstens ein während eines Prüfvorgangs notwendiger Verfahrensschritt oder der gesamte Prüfvorgang mittels einer Fernbedienung initiierbar. Die Verwendung einer Fernbedienung reduziert den benötigten Montageaufwand für die Prüfanordnung in vorteilhafter Weise und ermöglicht zudem eine einfachere Durchführung einer Wechselspannungsprüfung.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: ein Schnittbild durch eine exemplarische Hochspannungsdrossel,
- Fig. 2: eine Draufsicht auf erste Prüfanordnung,
- Fig. 3: eine Seitenansicht auf zweite Prüfanordnung sowie
- Fig. 4: ein Übersichtsbild eines Resonanzschwingkreises

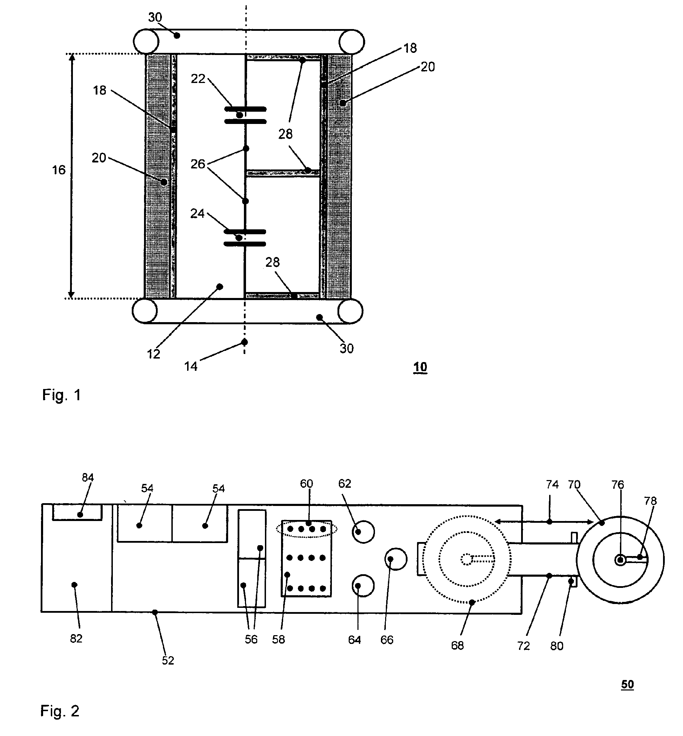

Fig. 1 zeigt ein Schnittbild durch eine exemplarische Hochspannungsdrossel 10. Um eine Wickelachse 14 ist radial ein rohrähnlicher Wickelkörper 18 mit der Länge 16 angeordnet, welcher vorzugsweise aus einem Isolationsmaterial gefertigt ist. Der Wickelkörper 18 umschließt radial den Innenraum 12. Um den Wickelkörper 18 ist eine Vielzahl von Windungen eines Wickelleiters der Wicklung der Hochspannungsdrossel 10 angeordnet, wobei die der Querschnitt der einzelnen Windungen hier als Wicklungsquerschnitt 20 angedeutet ist.

Längs der Wickelachse 14 und innerhalb des Innenraums 12 sind ein erster Kondensator 22 und ein zweiter Kondensator 24 angeordnet, welche in dieser Darstellung mit ihrem elektrischen Symbol gezeigt sind, in Wirklichkeit aber in einem entsprechenden Gehäuse untergebracht sind. Die Kondensatoren 22, 24 sind mechanisch / elektrisch längs der Wickelachse 14 über die Verbindungen 26 miteinander gekoppelt, so dass die Funktionalität eines Spannungsteilers gebildet ist. Eine derartige Verbindung 26 ist beispielsweise ein Metallstab mit genügender mechanischer Festigkeit. Die Verbindungen 26 sind in der axialen Mitte der Hochspannungsdrossel 10 und an deren beiden Enden jeweils über eine erste aus einem Isolationsmaterial bestehende Halterung 28 mit dem Wickelkörper 18 verbunden. An den beiden axialen Enden der Hochspannungsdrossel 10 ist je ein torusförmiger Elektrodenring 30 angeordnet, welcher die elektrische Potentialverteilung bei anliegender Spannung beeinflussen.

Fig. 2 zeigt eine Draufsicht auf erste Prüfanordnung 50. Auf der Bodenfläche eines quaderförmigen ersten Behälters 52, dessen Dachfläche hier nicht gezeigt ist, sind mehrere Prüfkomponenten eines erfindungsgemäßen Prüfsystems 50 dargestellt.

Zwei Wechselrichteranordnungen 54 sind im vorderen, in der Fig. links dargestellten, Bereich des ersten Behälters 52 angeordnet, welche mit einer nicht gezeigten Spannungsversorgung von beispielsweise 400V, 3phasig, 50 Hz verbunden sind. Die jeweiligen Verbindungsleitungen zwischen den einzelnen Komponenten sind in dieser Darstellung nicht gezeigt.

Im Falle einer 3-phasigen Wechselspannungsprüfung wird jede der drei erzeugten Wechselspannungen über den dreiphasigen ersten Prüftransformator 58 auf ein höheres Spannungsniveau transformiert und einem nicht gezeigten Prüfling zugeführt, wobei die jeweiligen Spannungen mit Spannungwandlern 62, 64, 66 zu Messzwecken auf eine niedrigere, messbare Spannung herunterformbar sind. Die Spannungswandler 62, 64, 66 haben beispielsweise eine Höhe von ca. 1 m und sind beispielsweise derart angeordnet, dass die Isolationsabstände innerhalb des Behälters und zu den Behälterwänden eine maximale Spannung von 220kV zulassen. Diese Spannung ist für derartige 3-phasige Wechselspannungsprüfungen hinreichend. Im Messraum 82 im linken dargestellten Bereich des ersten Behälters 52 sind Mess-Auswertevorrichtungen 84 vorgesehen, mit welchen zugeführte Messsignale erfasst, gespeichert und ausgewertet werden können. Ein Filter 56 ist dafür vorgesehen, die vom Wechselrichter 54 erzeugten Wechselspannungen gegebenenfalls zu glätten. Weiterhin sind auch Vorrichtungen zur Blindleistungskompensation erfindungsgemäß anordenbar, wobei die Blindleistungskompensation gegebenenfalls auch durch den Filter 56 erfolgen kann.

Eine erste Hochspannungsdrossel 68, 70 ist in gestrichelter Form im rechten inneren Bereich des ersten Behälters 52 in einer ersten Position angedeutet. In dieser ersten Position sind die für den Betrieb der ersten Hochspannungsdrossel 68, 70 notwendigen Isolationsabstände, beispielsweise zu den Seitenwänden des ersten Behälters 52 nicht eingehalten. Diese erste Position innerhalb des ersten Behälters 52 ist aber für Transportzwecke der Prüfanordnung geeignet.

Im Falle einer Resonanzprüfung wird die erste Hochspannungsdrossel 68, 70 in einem Resonanzschwingkreis mit dem Prüfling verschaltet. Eine Resonanzprüfung erfolgt 1-phasig, es wird also nur eine einzige Wechselspannung vom ersten Wechselrichter 54 erzeugt und es wird nur eine Hochspannungsdrossel 68, 70 benötigt. Die bei einer Resonanzprüfung auftretenden Spannungen sind oftmals höher, als die bei einer normalen Wechselspannungsprüfung, beispielsweise 500kV, weshalb die Spannungswandler 62, 64, 66 nicht zur direkten Verwendung geeignet sind.

Die erste Hochspannungsdrossel ist nunmehr in der zweiten Position 70 anzusehen, in welcher sie mittels der ersten Bewegungsvorrichtung 72 verbracht wurde, beispielsweise einer ausfahrbaren Teleskopschiene. Die erste Bewegungsvorrichtung 72 ist mittels einer Stützvorrichtung 80 gegenüber der Standfläche des ersten Behälters 52 abgestützt. Eine überhöhte Knickbeanspruchung der ersten Bewegungsvorrichtung 72 ist dadurch vermieden. Im Inneren der ausgefahrenen ersten Hochspannungsdrossel 70 ist weiterhin ein dritter Kondensator 76 sichtbar, welcher mittels einer Haltevorrichtung 78 im Mittelpunkt des Innenraumes gehalten ist. Dieser dritte Kondensator ist Teil eines Spannungsteilers, welcher in den Innenraum der Hochspannungsdrossel 68, 70 integriert ist. Die Hochspannungsdrossel 68, 70 und der Spannungsteiler haben beispielsweise eine lichte Höhe von ca. 2,5m, womit der integrierte Spannungsteiler sowie die Hochspannungsdrossel für Spannungen bis ca. 500kV geeignet sind.

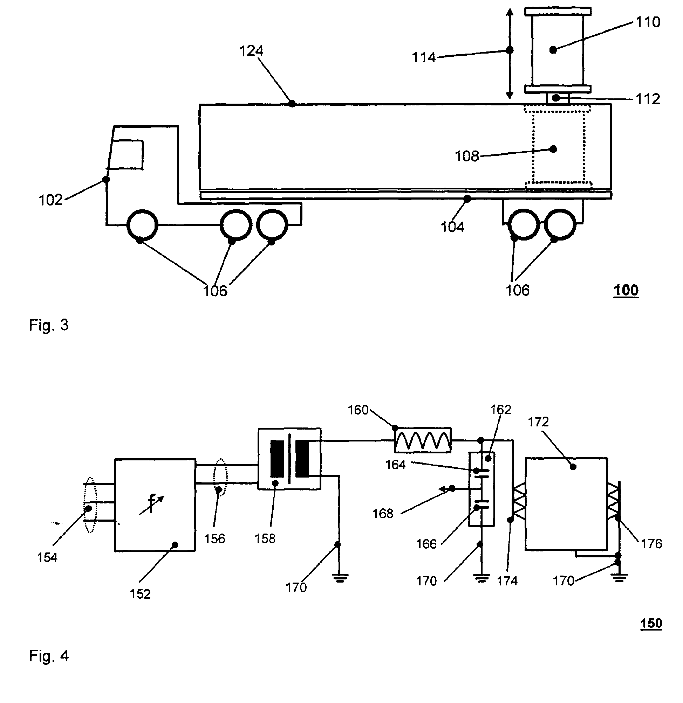

Fig. 3 zeigt eine Seitenansicht auf zweite Prüfanordnung 100. Eine zweite Hochspannungsdrossel in einer ersten Position 108 ist mit einer gestrichelten Linie innerhalb eines zweiten Behälters 124 angedeutet, wobei dieser vorzugsweise als 40-Fuß Container ausgeführt ist. Der zweite Behälter 124 ist auf einer ersten 102 und einer zweiten 104 Transportvorrichtung mit dazugehörigen Rädern 106 dargestellt, einem LKW mit einem Auflieger. Durch die Position innerhalb der Begrenzungen des zweiten Behälters 124 ist die zweite Hochspannungsdrossel 108 vorteilhaft geschützt transportierbar. Der zweite Behälter 124 ist beim Transport zu Schutzzwecken der Prüfanordnung vorzugsweise an allen sechs Seitenwänden verschlossen. Vor einem Bewegungsvorgang der zweiten Hochspannungsdrossel 108, 110 durch die äußere Begrenzung des zweiten Behälters 124 ist an diesem demgemäß zuvor eine Öffnung herzustellen, durch welche die zweite Hochspannungsdrossel 108, 110 von innen nach außen bewegbar ist. Hiezu ist wenigstens ein Segment der betreffenden Begrenzungswand zu entfernen oder zu verschieben, vorzugsweise mit einem Antriebsmechanismus oder aber auch manuell.

Weiterhin dargestellt ist die zweite Hochspannungsdrossel in einer zweiten Position 110 außerhalb des zweiten Behälters 124. Diese zweite Position ist von der ersten Position mittels einer zweiten Bewegungsvorrichtung 112, beispielsweise einer Hubvorrichtung, erreichbar. Die Bewegungsrichtung verläuft in der dargestellten Fig. senkrecht und ist mit dem Pfeil 114 gekennzeichnet. Es ist aber auch eine Bewegungsrichtung der zweiten Hochspannungsdrossel in horizontaler Richtung durch eine Seiten- oder Stirnfläche des zweiten Behälters 124 denkbar.

Fig. 4 zeigt ein schematisches Übersichtsschaltbild über einen Resonanzschwingkreis 150, zu welchem ein Teil der Prüfkomponenten für Prüfungen mit besonders hohen Spannungen zusammenschaltbar ist. Ein derartiger Resonanzschwingkreis ist einphasig, d..h. bei denen in Fig. 2 teilweise 3-phasig angedeuteten Prüfkomponenten wie Prüftransformator oder Spannungswandlern wird in dieser Anordnung jeweils nur eine Phase benutzt.

Ein Wechselrichter 152 ist über seine Eingänge 154 3-phasig mit einer Spannungsversorgung vor Ort verbunden, beispielsweise 400V, 50Hz. An den Ausgängen 156 des Wechselrichters 152, welche mit den Anschlüssen der Unterspannungsseite eines zweiten Prüftransformators 158 verbunden sind, liegt während des Betriebes eine geregelte Wechselspannung an, welche vorzugsweise mit nicht dargestellten Filtern geglättet wird. Die Frequenz der Wechselspannung ist derart geregelt, dass der Resonanzschwingkreis in seiner Resonanzfrequenz angeregt wird. Der Resonanzschwingkreis weist in der Hauptsache eine vierte Hochspannungsdrossel 160, einen Prüfling 172 und einen kapazitiven Spannungsteiler 162 auf. Die Komponenten sind derart aufeinander abgestimmt, dass sich eine Resonanzfrequenz von etwas über den üblichen 50Hz Netzfrequenz ergibt, beispielsweise 100Hz, wobei diese insbesondere von den Kenndaten des zu testenden Prüflings abhängt. Der Prüfling 172 ist in der dargestellten Fig. ein 3-phasiger Leistungstransformator, dessen unterspannungsseitigen Anschlüsse jeweils mit einer Erdung 170 verbunden sind und dessen oberspannungsseitigen Anschlüsse 174 elektrisch parallel zueinander im Schwingkreis verschaltet sind.

In einer derartigen Anordnung sind Spannungen bis zu beispielsweise 500kV erzeugbar, welche mit dem die beiden Kondensatoren 164 und 166 aufweisenden Spannungsteiler 162 messbar sind. Die Spannung ist Führungsgröße für die Frequenzregelung des Wechselrichters 152.

### Bezugszeichenliste

- 10: Schnittbild durch eine exemplarische Hochspannungsdrossel
- 12: Innenraum
- 14: Wickelachse
- 16: Länge des Innenraumes
- 18: Wickelkörper
- 20: Wicklungsquerschnitt
- 22: erster Kondensator
- 24: zweiter Kondensator
- 26: Verbindung
- 28: erste Halterung
- 30: Elektrode
- 50: Draufsicht auf erste Prüfanordnung
- 52: erster Behälter
- 54: erster Wechselrichter
- 56: Filter
- 58: erster Prüftransformator
- 60: Anschlüsse erster Prüftransformator
- 62: erster Spannungswandler
- 64: zweiter Spannungswandler
- 66: dritter Spannungswandler
- 68: erste Hochspannungsdrossel in erster Position
- 70: erste Hochspannungsdrossel in zweiter Position
- 72: erste Bewegungsvorrichtung
- 74: erste Bewegungsrichtung
- 76: dritter Kondensator
- 78: zweite Halterung
- 80: Stützvorrichtung
- 82: Messraum
- 84: Mess- / Auswertevorrichtung
- 100: Seitenansicht auf zweite Prüfanordnung
- 102: erste Transportvorrichtung
- 104: zweite Transportvorrichtung
- 106: Rad
- 108: zweite Hochspannungsdrossel in erster Position
- 110: zweite Hochspannungsdrossel in zweiter Position
- 112: zweite Bewegungsvorrichtung
- 114: zweite Bewegungsrichtung
- 124: zweiter Behälter
- 150: Übersichtsbild Resonanzschwingkreis
- 152: zweiter Wechselrichter
- 154: Eingänge des zweiten Wechselrichters
- 156: Ausgänge des zweiten Wechselrichters
- 158: zweiter Prüftransformator
- 160: vierte Hochspannungsdrossel
- 162: Spannungsteiler
- 164: vierter Kondensator
- 166: fünfter Kondensator
- 168: Messspannungsausgang
- 170: Erdung
- 172: Leistungstransformator
- 174: kurzgeschlossene oberspannungsseitige Anschlüsse
- 176: kurzgeschlossene unterspannungsseitige Anschlüsse

## Patentansprüche

1. Hochspannungsdrossel (10, 68, 70, 108, 110, 160) mit wenigstens einem elektrischen Leiter, welcher in einer Vielzahl von Windungen um eine Wickelachse angeordnet (14) ist, wobei die Windungen radial einen Innenraum (12) längs der Wickelachse (14) umschließen, **dadurch gekennzeichnet, dass** in diesem Innenraum (12) wenigstens eine elektrische Innenkomponente (22, 24, 76, 164, 166) angeordnet ist.

2. Hochspannungsdrossel nach Anspruch 1, **dadurch gekennzeichnet, dass** die wenigstens eine elektrische Innenkomponente (22, 24, 76, 164, 166) ein Kondensator, ein Widerstand, eine Induktivität oder eine Funkenstrecke ist.

3. Hochspannungsdrossel nach einem der Ansprüche 1 oder 2, **dadurch gekennzeichnet, dass** diese (10) und wenigstens eine elektrische Innenkomponente (22, 24, 76, 164, 166) für eine Nennspannung von wenigstens 50kV ausgelegt sind.

4. Hochspannungsdrossel nach einem der vorherigen Ansprüche, **dadurch gekennzeichnet, dass** wenigstens eine elektrische Innenkomponente elektrisch mit wenigstens einer weiteren elektrischen Komponente verschaltet ist.

5. Hochspannungsdrossel nach Anspruch 4, **dadurch gekennzeichnet, dass** wenigstens 2 Kondensatoren (22, 24, 76, 164, 166) in elektrischer Reihenschaltung längs der Wickelachse (14) als Innenkomponenten (22, 24, 76, 164, 166) angeordnet sind.

6. Hochspannungsdrossel nach einem der Ansprüche 4 oder 5, **dadurch gekennzeichnet, dass** durch die verschalteten Komponenten (22, 24, 164, 166) die Funktionalität eines Spannungsteilers (162) gebildet ist.

7. Prüfanordnung (50) zur Wechselspannungsprüfung von elektrischen Hochspannungskomponenten (172) mit wenigstens einem Wechselrichter (54, 152), mit wenigstens einem Prüftransformator (58, 158) und mit wenigstens einer Hochspannungsdrossel (10, 68, 70, 108, 110, 160) als Prüfkomponenten, wobei wenigstens die genannten Prüfkomponenten in einem gemeinsamen quaderförmigen Behälter (52, 124) angeordnet sind, **dadurch gekennzeichnet, dass** die wenigstens eine Hochspannungsdrossel (10, 68, 70, 108, 110, 160) nach einem der Ansprüche 1 bis 6 ausgeführt ist.

8. Prüfanordnung nach Anspruch 7, **dadurch gekennzeichnet, dass** die wenigstens eine elektrische Innenkomponente (22, 24, 76, 164, 166) der Hochspannungsdrossel (10, 68, 70, 108, 110, 160) als Teil eines elektrischen Spannungsteilers (162) in der Prüfanordnung verschaltet ist.

9. Prüfanordnung nach Anspruch 8, **dadurch gekennzeichnet, dass** diese einen elektrischen Resonanzschwingkreis (150) mit wenigstens der Hochspannungsdrossel (10, 68, 70, 108, 110, 160) und einer zu prüfenden Hochspannungskomponente (172) sowie den damit verschalteten Spannungsteiler (162) umfasst.

10. Prüfanordnung nach Anspruch 9, **dadurch gekennzeichnet, dass** der Resonanzschwingkreis (150) mittels des Wechselrichters (54, 152) und des mit diesem elektrisch verbundenen Prüftransformators (58, 158) anregbar ist.

11. Prüfanordnung nach einem der Ansprüche 7 bis 10, **dadurch gekennzeichnet, dass** die Hochspannungsdrossel (10, 68, 70, 108, 110, 160) mittels einer Bewegungsvorrichtung (72, 112) durch wenigstens eine Öffnung an einer Begrenzungsfläche des Behälters (52, 124) zumindest teilweise aus diesem bewegbar ist.

12. Prüfanordnung nach Anspruch 11, **dadurch gekennzeichnet, dass** die wenigstens eine Öffnung an der oberen Begrenzungsfläche des Behälters (52, 124) befindlich ist und die Bewegungsvorrichtung (72, 112) vorwiegend in vertikaler Richtung (114) wirkt.

13. Prüfanordnung nach Anspruch 11, **dadurch gekennzeichnet, dass** die wenigstens eine Öffnung an einer senkrechten Begrenzungsfläche des Behälters (52, 124) befindlich ist und die Bewegungsvorrichtung (72, 112) vorwiegend in horizontaler Richtung (74) wirkt.

14. Prüfanordnung nach Anspruch 13, **dadurch gekennzeichnet, dass** die Bewegungsvorrichtung (72, 112) mit der zumindest teilweise aus dem Behälter bewegten Hochspannungsdrossel nach unten mittels einer Stützvorrichtung (80) abstützbar ist.

15. Prüfanordnung nach einem der Ansprüche 11 bis 14, **dadurch gekennzeichnet, dass** die wenigstens eine Öffnung verschließbar ist.

16. Prüfanordnung nach einem der Ansprüche 7 bis 15**, dadurch gekennzeichnet, dass** der Behälter (52, 124) mit einer Transportvorrichtung (102, 104) verbunden ist, welche sie tragende Räder (106) aufweist.

17. Prüfanordnung nach einem der Ansprüche 7 bis 16, **dadurch gekennzeichnet, dass** der Behälter (52, 124) ein transportierbarer Container mit Standardabmessungen ist.

18. Prüfanordnung nach Anspruch 17, **dadurch gekennzeichnet, dass** der Container gemäß CSC zugelassen ist.

19. Prüfanordnung nach einem der Ansprüche 7 bis 18, **dadurch gekennzeichnet, dass** die Prüfkomponenten (10, 54, 56, 58, 62, 64, 66, 68, 70, 108, 110, 152, 158, 160) zumindest teilweise mittels isolierten Hochspannungskabeln elektrisch miteinander verbunden sind.

20. Prüfanordnung nach einem der Ansprüche 7 bis 19, **dadurch gekennzeichnet, dass** wenigstens ein während eines Prüfvorgangs notwendiger Verfahrensschritt oder der gesamte Prüfvorgang mittels einer Fernbedienung initiierbar ist.
